Europäisches Patentamt

European Patent Office

Office européen des brevets

(19)

(11) Veröffentlichungsnummer: **0 236 352**
**B1**

(12) # EUROPÄISCHE PATENTSCHRIFT

(45) Veröffentlichungstag der Patentschrift: **28.11.90**

(51) Int. Cl.⁵: **H 01 L 23/52**

(21) Anmeldenummer: **86904783.7**

(22) Anmeldetag: **25.08.86**

(86) Internationale Anmeldenummer:
**PCT/DE86/00327**

(87) Internationale Veröffentlichungsnummer:
**WO 87/01867 26.03.87 Gazette 87/07**

(54) **MULTIZELLENTRANSISTOR.**

(30) Priorität: **11.09.85 DE 3532383**

(43) Veröffentlichungstag der Anmeldung:
**16.09.87 Patentblatt 87/38**

(45) Bekanntmachung des Hinweises auf die
Patenterteilung:
**28.11.90 Patentblatt 90/48**

(84) Benannte Vertragsstaaten:
**DE FR GB**

(56) Entgegenhaltungen:
**DE-A-2 502 452**
**FR-A-2 262 409**
**GB-A-1 131 210**
**US-A-4 354 217**

(73) Patentinhaber: **ROBERT BOSCH GMBH**
**Postfach 50**
**D-7000 Stuttgart 1 (DE)**

(72) Erfinder: **CONZELMANN, Gerhard**
**Wilhelmstr. 37**
**D-7022 Leinfelden-Echterdingen 1 (DE)**
Erfinder: **NAGEL, Karl**
**Grundstr. 24**
**D-7413 Gomaringen (DE)**

Courier Press, Leamington Spa, England.

## Beschreibung

### Stand der Technik

Die Erfindung geht aus von einem Multizellentransistor nach der Gattung des Hauptanspruches.

Ein derartiger Multizellentransistor ist bereits aus der DE-PS 24 08 540 bekannt. Der Multizellentransistor besteht aus einer Parallelschaltung einzelner Transistorzellen zwischen je eine gemeinsame Basis-, Emitter- und Kollektoranschlußschiene und ist vorzugsweise in integrierter Technik aufgebaut. Der besondere Nachteil eines solchen Multizellentransistors ist darin zu sehen, daß bei einem Kurzschlußdefekt einer einzigen Transistorzelle der gesamte Multizellentransistor betriebsunfähig wird. Derartige Defekte können bei der Produktion aufgrund von Fertigungsstreuungen oder Verunreinigungen während der Herstellung auftreten, sie können aber auch während des Betriebes durch lokale thermische Überlastung oder plötzlich auftretende Überspannung verursacht werden. Die aufgrund der Herstellung defekten Transistorzellen lassen sich durch einzelnes Nachmessen lokalisieren und aus dem Verbund durch Durchbrennen der Brennstrecken herauslösen.

Die während des Betriebes des Multizellentransistors defekt werdenden Transistorzellen müssen sich dagegen selbsttätig abtrennen können, damit ein sogenannter Selbstheileffekt erreicht wird.

### Vorteile der Erfindung

Der erfindungsgemäße Multizellentransistor mit den kennzeichnenden Merkmalen des Hauptanspruches hat demgegenüber den Vorteil, daß eine besonders sichere selbsttätige Heraustrennung einer defekten Transistorzelle erreicht wird. Dadurch ist es möglich, in integrierter Technik breitere Strukturen für die Basisbrennstrecke zu verwenden und die Anforderungen an die Fertigungsgenauigkeit zu senken.

In den Unteransprüchen sind besonders vorteilhafte Ausgestaltungen der Erfindung angegeben. So ist es besonders einfach, den spannungsgestörten Schalter durch eine einzige Zenerdiode darzustellen, die in integrierter Technik besonders einfach durch einen in Sperrichtung betriebenen Transistor dargestellt werden kann, dessen Basis und Kollektor miteinander verbunden sind. Eine besonders vorteilhafte Schaltcharakteristik des spannungsgesteuerten Schalters wird durch Verwendung eines Thyristors erreicht. Dieser kann durch eine Zenerdiode oder durch einen Spannungsteiler gezündet werden. In monolithisch integrierter Technik ist dieser Thyristor besonders einfach durch eine Verbindung eines pnp- mit einem npn-Transistor darstellbar.

### Zeichnung

Drei Ausführungsbeispiele der Erfindung sind in der Zeichnung dargestellt und in der nachfolgenden Beschreibung näher erläutert. Figur 1 zeigt die Prinzipschaltung eines erfindungsgemäßen Multizellentransistors; Figur 2 zeigt eine Transistorzelle nach dem ersten Ausführungsbeispiel; Figur 3 zeigt eine Transistorzelle nach dem zweiten Ausführungsbeispiel; Figur 4 zeigt eine Transistorzelle nach dem dritten Ausführungsbeispiel; Figur 5 zeigt eine Aufsicht auf eine Transistorzelle gemäß dem ersten Ausführungsbeispiel; Figur 6 zeigt eine Aufsicht auf eine Transistorzelle gemäß dem zweiten Ausführungsbeispiel.

### Beschreibung der Ausführungsbeispiele

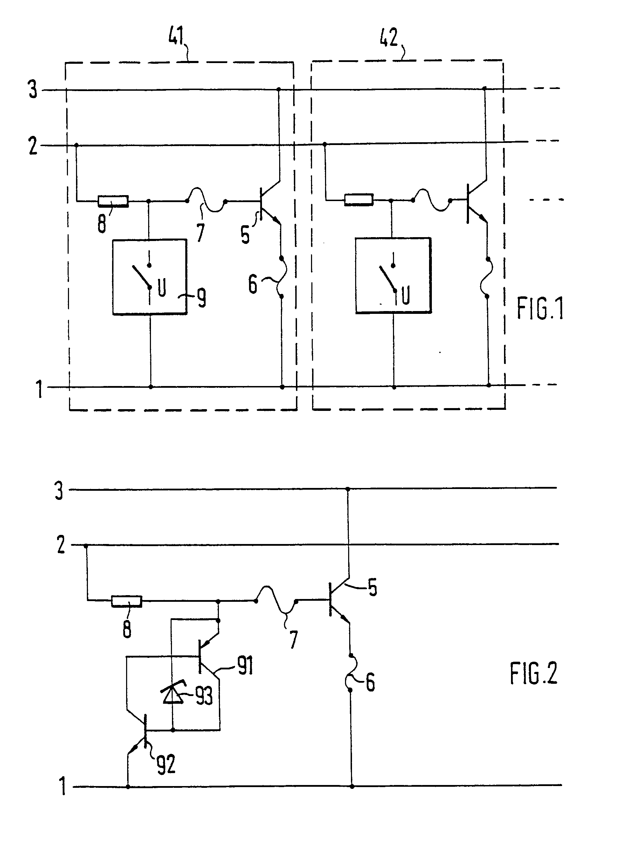

In Figur 1 ist eine Emittersammelschiene 1, Basissammelschiene 2 und eine Kollektorsammelschiene 3 eines erfindungsgemäßen Multizellentransistors dargestellt, von dem aus Vereinfachungsgründen in der Figur 1 nur eine erste Transistorzelle 41 und eine zweite Transistorzelle 42 dargestellt sind. Weitere nicht dargestellte Transistorzellen sind parallel geschaltet, so daß sich eine geringe Leistungsaufteilung auf jede einzelne Transistorzelle des gesamten Multizellentransistors ergibt.

Die Transistorzelle 41 beinhaltet einen Endtransistor 5, der mit seinem Kollektor an die Kollektorsammelschiene 3 und mit seinem Emitter über eine Emitterbrennstrecke 6 an die Emittersammelschiene 1 geschaltet ist. Eine weitere Brennstrecke ist als Basisbrennstrecke 7 an die Basis des Endtransistors 5 und über einen Basiswiderstand 8 an die Basissammelschiene 2 geschaltet. Weiterhin ist ein spannungsgesteuerter Schalter 9 zwischen den Verbindungspunkt der Basisbrennstrecke 7 und des Basiswiderstandes 8 und die Emittersammelschiene 1 geschaltet.

Die in Figur 1 prinzipiell dargestellte Schaltung funktioniert in folgender Weise. Tritt während des Betriebes des Multizellentransistors an einer Transistorzelle ein Defekt auf, der einen Kurzschluß im Endtransistor 5 bedeutet, so tritt ein hoher Kurzschlußstrom zwischen der Kollektorsammelschiene 3 und der Emittersammelschiene 1 über den defekten Endtransistor 5 auf, der die Emitterbrennstrecke 6 zum Durchtrennen bringt. Danach ist die Basis des defekten Endtransistors 5 über den Kollektor nahezu an das Potential der Kollektorsammelschiene 3 gezogen. Der spannungssteuerte Schalter 9 schließt selbsttätig, so daß ein hoher Strom durch die Basisbrennstrecke 7 fließt, der schließlich auch die Basisbrennstrecke 7 auftrennt. Damit ist die defekte Transistorzelle vollkommen aus dem Multizellentransistorverbund herausgelöst.

In Figur 2 ist ein erstes Ausführungsbeispiel der Erfindung dargestellt, wobei wie bei Figur 1 mit 5 der Endtransistor, mit 6 die Emitterbrennstrecke, mit 7 die Basisbrennstrecke und mit 8 der Basiswiderstand bezeichnet sind. Der spannungsgesteuerte Schalter 9 ist durch einen Thyristor realisiert, der in bekannter Weise durch einen pnp-Transistor 91 in Verbindung mit einem npn-Transistor 92 dargestellt ist. Hierzu ist die Basis des pnp-Transistors 91 mit dem Kollektor des npn-Transistors 92 und der Kollektor des pnp-Transistors 91 mit der Basis des npn-Transistors 92 verbunden. Der Emitter des pnp-Transistors 91 liegt an der Basisbrennstrecke 7 und der Emitter des npn-Transistors 92 an der Emittersammelschiene 1. Eine Zenerdiode 93 ist mit ihrer Kathode an den Emitter des pnp-Transistors 91 geschaltet, ihre Anode liegt an der Basis des npn-Transistors 92. Sie dient zum Zünden des Thyristors.

Tritt nun ein Kurzschluß im Endtransistor 5 auf, der zuerst die Emitterbrennstrecke 6 durchtrennt, so wird durch das sich anhebende Potential der Basis des defekten Endtransistors 5 die Zenerdiode 93 in den stromleitenden Zustand gebracht, wodurch der durch die Transistoren 91, 92 gebildete Thyristor zündet und die Basisbrennstrecke 7 durchtrennt wird.

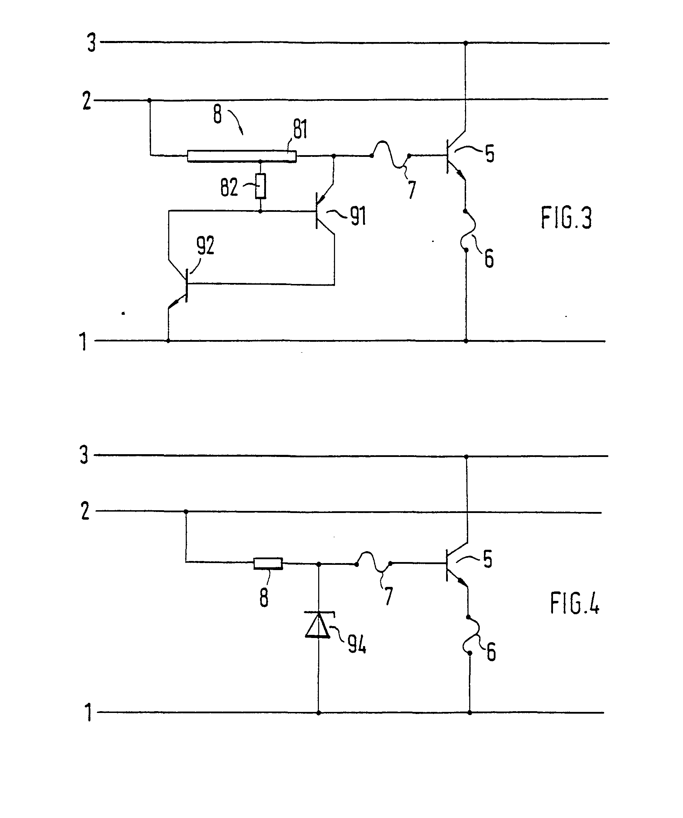

In Figur 3 ist ein zweites Ausführungsbeispiel der Erfindung anhand einer einzelnen Transistorzelle dargestellt. Wie in Figur 2 ist mit 5 der Endtransistor, mit 6 die Emitterbrennstrecke, mit 7 die Basisbrennstrecke, mit 91 der pnp-Transistor und mit 92 der npn-Transistor des gebildeten Thyristors dargestellt. Die Zündung des Thyristors geschieht nun aber nicht durch eine Zenerdiode, sondern durch eine besondere Ausgestaltung des Basiswiderstandes 8, der in Figur 3 durch einen Basiswiderstand 81 und einen Teilerwiderstand 82 gebildet wird. Hierzu ist der Teilerwiderstand 82 zwischen die Basis des pnp-Transistors 91 und einen Teilerpunkt des Basiswiderstandes 81 geschaltet. Ansonsten ist die Funktionsweise der Schaltung gemäß Figur 3 äquivalent zu der gemäß Figur 2.

In Figur 4 ist ein drittes Ausführungsbeispiel der Erfindung anhand einer einzelnen Transistorzelle dargestellt. Wie bei den vorherigen Beispielen ist mit 5 wiederum der Endtransistor, mit 6 die Emitterbrennstrecke, mit 7 die Basisbrennstrecke und mit 8 der Basiswiderstand gekennzeichnet. Als Schalter dient nun aber eine einzige Zenerdiode 94, die hierfür zwischen die Basisbrennstrecke 7 und die Emittersammelschiene 1 geschaltet ist. Auch hier ist die Funktionsweise der Schaltung gemäß Figur 4 äquivalent zu der gemäß den beiden vorhergehenden Ausführungsbeispielen.

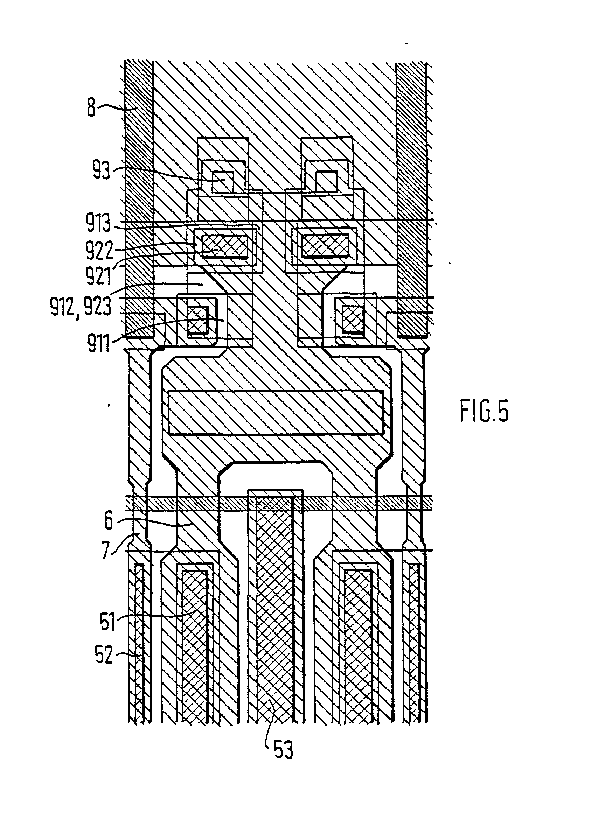

In Figur 5 ist die Aufsicht auf eine integrierte Transistorzelle gemäß dem ersten Ausführungsbeispiel nach Figur 2 dargestellt. Deutlich sind die breite Emitterbrennstrecke 6, die einen hohen Strom durchlassen kann, und die im Vergleich hierzu relativ schmale Basisbrennstrecke 7 zu erkennen. Der Emitter des Endtransistors 5 ist mit 51 gekennzeichnet, entsprechend sind dessen Basis mit 52 und dessen Kollektor mit 53 gekennzeichnet. Die Basisbrennstrecke 7 führt auf den Basiswiderstand 8, wobei an deren Verbindungskontaktierung der Emitter 911 des pnp-Transistors 91 des Thyristors angeschlossen ist. Mit 912 bzw. 923 ist die Basis des pnp-Transistors 91 bzw. der gleichzeitig gebildete Kollektor des npn-Transistors 92 gekennzeichnet. Das Diffusionsgebiet mit der Bezeichnung 913 stellt den Kollektor des pnp-Transistors 91 dar. Mit 921 ist weiterhin der Emitter und mit 922 die Basis des npn-Transistors 92 dargestellt. Oberhalb des hierdurch gebildeten Thyristors ist in der Zeichnung das Diffusionsgebiet 93 dargestellt, das die gleichbezeichnete Zenerdiode gemäß Figur 2 darstellt.

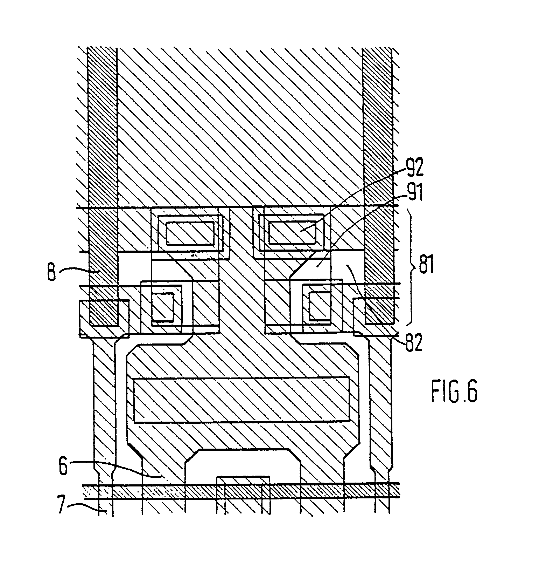

In Figure 6 ist die Aufsicht auf eine integrierte Schaltung gemäß dem zweiten Ausführungsbeispiel nach Figur 3 dargestellt. Wie in Figur 5 ist mit 6 die Emitterbrennstrecke und mit 7 die Basisbrennstrecke dargestellt, die zum Basiswiderstand 8 führt. Auf der rechten Seite der Figur 6 ist mit 81 der Bereich des Basiswiderstandes 8 näher gekennzeichnet, wie er dem gleich bezeichneten Teilerwiderstand des Basiswiderstandes 8 in der Figur 3 entspricht. Der Teilerwiderstand 82 wird durch das in Figur 6 gleichbezeichnete Epitaxiegebiet dargestellt. Weiterhin sind der pnp-Transistor 91 und der npn-Transistor 92 des Thyristors dargestellt.

**Patentansprüche**

1. Multizellentransistor bestehend aus einer parallelschaltung einzelner Transistorzellen (41, 42) zwischen je einer gemeinsamen Basis-, Emitter- und Kollektorsammelschiene (1, 2, 3), wobei in die Kollektor-Emitter-Strecke und in den Basisanschluß jeder Transistorzelle (41, 42) je eine Brennstrecke (6, 7) geschaltet ist, dadurch gekennzeichnet, daß jeweils zwischen der Emittersammelschiene (1) und dem der Basis abgewandten Anschlußpunkt der Brennstrecke (7) des Basisanschlusses ein spannungsgesteuerter Schalter (9) zur selbsttätigen Durchtrennung dieser Brennstrecke (7) im Fehlerfall geschaltet ist.

2. Multizellentransistor nach Anspruch 1, dadurch gekennzeichnet, daß zwischen die Brennstrecke (7) des Basisanschlusses und die Basissammelschiene (2) ein Widerstand (8) geschaltet ist.

3. Multizellentransistor nach Anspruch 2, dadurch gekennzeichnet, daß der Widerstand (8) durch wenigstens eine Halbleiterstrecke, vorzugsweise eine Diode, gebildet wird.

4. Multizellentransistor nach einem der vorhergehenden Ansprüche, dadurch gekennzeichnet, daß der spannungsgesteuerte Schalter (9) durch eine Zenerdiode (94) gebildet wird.

5. Multizellentransistor nach einem der Ansprüche 1 bis 3, dadurch gekennzeichnet, daß der spannungsgesteuerte Schalter durch einen Thyristor (91, 92) gebildet wird.

6. Multizellentrensistor nach Anspruch 5, dadurch gekenn zeichnet, daß der Thyristor (91, 92) durch eine an die Brennstrecke (7) des Basisanschlusses angeschlossene Zener diode (93) gezündet wird.

7. Multizellentransistor nach Anspruch 5, dadurch gekennzeichnet, daß der Thyristor durch einen Widerstand (82) gezündet wird, der an ein vom Basispotential des Endtransistors (5) abhängiges Bauteil (81) geschaltet ist.

8. Multizellentransistor nach einem der Ansprüche 5 bis 7, dadurch gekennzeichnet, daß der Thyristor aus einem pnp-Transistor (91) und einem npn-Transistor (92) gebildet wird.

**Revendications**

1. Transistor à cellules multiples formé d'un montage en parallèle de différentes cellules de transistor (41, 42) entre chaque fois un rail commun pour la base, l'émetteur et le collecteur (1, 2, 3), le chemin collecteur-émetteur et le branchement de la base de chaque cellule de transistor (41, 42) étant munis chaque fois d'un chemin fusible (6, 7), transistor caractérisé en ce que chaque fois entre le rail d'émetteur (1) et le point de branchement opposé à la base pour le chemin fusible (7) du branchement de base il est prévu un commutateur (9) commandé en tension pour couper automatiquement ce chemin fusible (7) en cas de défaut.

2. Transistor à cellules multiples selon la revendication 1, caractérisé en ce qu'entre le chemin fusible (7) du raccordement de la base et le rail de base (2) on a branché une résistance (8).

3. Transistor à cellules multiples selon la revendication 2, caractérisé en ce que la résistance (8) est formée par au moins un chemin semi-conducteur, de préférence une diode.

4. Transistor à cellules multiples selon l'une des revendications précédentes, caractérisé en ce que le commutateur commandé en tension (9) est formé par une diode Zener (94).

5. Transistor à cellules multiples selon l'une des revendications 1 à 3, caractérisé en ce que le commutateur commandé en tension est formé par un thyristor (91, 92).

6. Transistor à cellules multiples selon la revendication 5, caractérisé en ce que le thyristor (91, 92) est déclenché par une diode Zener (93) reliée au chemin fusible (7) du branchement de la base.

7. Transistor à cellules multiples selon la revendication 5, caractérisé en ce que le thyristor est déclenché par une résistance (82) qui est reliée à un composant (81) dépendant du potentiel de base du transistor de sortie (5).

8. Transistor à cellules multiples selon l'une des revendications 5 à 7, caractérisé en ce que le thyristor est formé d'un transistor pnp (91) et d'un transistor npn (92).

**Claims**

1. Multicell transistor consisting of a parallel connection of individual transistor cells (41, 42) between in each case one common base, emitter and collector busbar (1, 2, 3), in each case a burn-through section (6, 7) being connected in each case into the collector emitter path and into the base terminal of each transistor cell (41, 42), characterized in that in each case a voltage-controlled switch (9) for the automatic disconnection of this burn-through section (7) in the event of a fault is connected between the emitter busbar (1) and the connection point, facing away from the base, of the burn-through section (7) of the base terminal.

2. Multicell transistor according to Claim 1, characterized in that a resistor (8) is connected between the burn-through section (7) of the base terminal and the base busbar (2).

3. Multicell transistor according to Claim 2, characterized in that the resistor (8) is formed by at least one semiconductor section, preferably a diode.

4. Multicell transistor according to one of the preceding claims, characterized in that the voltage-controlled switch (9) is formed by a Zener diode (94).

5. Multicell transistor according to one of Claims 1 to 3, characterized in that the voltage-controlled switch is formed by a thyristor (91, 92).

6. Multicell transistor according to Claim 5, characterized in that the thyristor (91, 92) is fired by a Zener diode (93) connected to the burn-through section (7) of the base terminal.

7. Multicell transistor according to Claim 5, characterized in that the thyristor is fired by a resistor (82) which is connected to a component (81) which is dependent on the base potential of the final transistor (5).

8. Multicell transistor according to one of Claims 5 to 7, characterized in that the thyristor is formed from a pnp type transistor (91) and a npn type transistor (92).

FIG.1

FIG.2

FIG.3

FIG.4

FIG.5

FIG.6